# EUROPÄISCHE PATENTSCHRIFT

(11) **EP 1 609 341 B1**
(45) Veröffentlichungstag und Bekanntmachung des Hinweises auf die Patenterteilung: **06.04.2011**
(21) Anmeldenummer: 04703348.5
(22) Anmeldetag: 20.01.2004
(51) Int. Cl.: H05K 5/06

(54) **ANORDNUNG ZUM ELEKTRISCHEN VERBINDEN**
ARRAY FOR ELECTRICAL CONNECTION
DISPOSITIF DE CONNEXION ELECTRIQUE

(30) Priorität: 03.04.2003 DE 10315432
(43) Veröffentlichungstag der Anmeldung: 28.12.2005
(73) Patentinhaber: Conti Temic microelectronic GmbH, 90411 Nürnberg (DE)
(72) Erfinder: BÜYÜKBAS, Turhan, 95158 Kirchenlamitz (DE); GUTH, Peter, 90419 Nürnberg (DE); GRAMANN, Matthias, 91233 Neunkirchen a.S. (DE); SCHARRER, Klaus, 91224 Hohenstadt (DE); BUHL, Joachim, 90408 Nürnberg (DE); SCHUCH, Bernhard, 91616 Neusitz (DE); KLEIN, Dominik, 90411 Nürnberg (DE); LIEBL, Tilo, 91217 Hersbruck (DE)
(86) Internationale Anmeldenummer: PCT/DE2004/000064
(87) Internationale Veröffentlichungsnummer: WO 2004/091270

(56) Entgegenhaltungen:
- DE-C- 10 051 945
- DE-C- 19 751 095
- FR-A- 2 795 832
- US-B1- 6 279 527
- US-B1- 6 320 128

## Beschreibung

Die Erfindung betrifft eine Anordnung zum elektrischen Verbinden einer elektrischen Einheit, die zumindest eine elektrische Baugruppe umfasst und im Inneren eines Gehäuses angeordnet ist, mit wenigstens einem außerhalb des Gehäuses vorgesehenen elektrischen Bauteil mittels eines flexiblen Folienleiters.

In der Patentschrift DE 197 51 095 C1 wird die Anordnung einer Steuereinheit im Inneren eines Getriebegehäuses eines Kraftfahrzeuges beschrieben, bei der das elektrische Verbindungselement zwischen der Steuereinheit und den elektrischen Bauteilen außerhalb des Gehäuses aus einem einzigen flexiblen Folienleiter besteht und eine Doppelfunktion ausübt, nämlich zum einen die Steuereinheit mit den elektrischen Bauteilen außerhalb des Gehäuses zu verbinden und zum anderen mehrere im Gehäuse vorhandene Bauteile gemeinsam zu kontaktieren. Die Steuereinheit umfasst wenigstens zwei öldicht miteinander verbundene Gehäuseteile, durch die das elektrische Verbindungselement hindurchgeführt ist.

Die Patentschrift US 6,279,527 B1 offenbart eine Abdeckung für einen Einlassstutzen in einer Brennkraftmaschine mit n Zylindern und einen zwischen der Abdeckung und dem Einlassstutzen angeordneten flexiblen Folienleiter zum Leiten elektrischer Signale in der Brennkraftmaschine. Der Folienleiter beinhaltet eine elektronische Einheit und besteht im wesentlichen aus einer Grundfläche und n sich von der Grundfläche weg erstreckenden Streifen. Jeder Streifen ist in der Nähe eines entsprechenden Zylinders angeordnet.

Der flexible Folienleiter ist dabei jeweils aus einem Stück, was bei komplexen Anordnungen, rechnet man nur die Aussparung für die Steuereinheit in der Mitte des Folienleiters, zu einem großen Verschnitt führt und deshalb unwirtschaftlich ist. Darüber hinaus ist mit der Form des Folienleiters die Position der elektrischen Bauteile sowohl innerhalb als auch außerhalb des Gehäuses festgelegt und erfordert bei der Änderung der Lage nur eines Bauteiles die Änderung der Form des ganzen Folienleiters. Im Herstellungsprozess stellt dies eine gravierende Einschränkung der Gestaltungsmöglichkeiten dar.

Ein weiterer Nachteil dieser Anordnung ist, dass die Funktions- und Qualitätsprüfung, beispielsweise bezüglich der Dichtheit der Anordnung oder der Güte der elektrischen Kontakte, erst sehr spät im Herstellungsprozess geprüft werden kann. Was unter Umständen sehr teuere Nacharbeit oder sogar hohe Ausschusskosten zur Folge haben kann.

Der vorliegenden Erfindung liegt die Aufgabe zugrunde, eine einfache, flexibel handhabbare, wirtschaftliche und prozesssichere Anordnung zum elektrischen Verbinden einer zumindest eine elektrische Baugruppe umfassenden elektrischen Einheit innerhalb eines abgedichteten Gehäuses mit außerhalb des Gehäuses liegenden elektrischen Bauteilen zu schaffen.

Diese Aufgabe wird durch eine Anordnung mit den Merkmalen des Anspruches 1 gelöst.

Dadurch, dass die elektrische Verbindung zwischen den elektrischen Baugruppen innerhalb des Gehäuses mit den zugehörigen elektrischen Bauteilen außerhalb des Gehäuses nicht durch einen einzigen großen Folienleiter, sondern durch jeweils einen separaten, in Größe und Form genau angepassten, Folienleiter hergestellt wird, gibt es so gut wie keinen Folienverschnitt. Die Anordnung ist also bezüglich des sehr teuren Folienleiters kostenoptimiert. Darüber hinaus bietet die Anordnung den Vorteil, dass die Leiterbahnen des Folienleiters im Vergleich mit der Einfolienlösung nur noch aus parallelen Geraden bestehen und damit das Folienlayout vereinfacht und dadurch kostengünstiger wird.

Nach einem bevorzugten Ausführungsbeispiel der vorliegenden Erfindung umfasst das Gehäuse vorzugsweise einen Deckel, eine umlaufende Wandung, die Grundplatte, die vorzugsweise einstückig mit der Wandung ausgebildet ist, und wenigstens eine Trägerplatte. Dadurch wird eine kompakte Gehäusebauweise erreicht.

Die elektrische Einheit im Inneren des Gehäuses ist insbesondere mit einem Abstand zur umlaufenden Wandung auf der Grundplatte montiert, wobei sich die Trägerplatte zwischen der Wandung und der elektrischen Einheit befindet. Die Grundplatte weist dabei vorzugsweise benachbart zu einer Baugruppe zwischen der Wandung und der elektrischen Einheit eine Aussparung auf. Die Trägerplatte ist nun insbesondere so in die Aussparung in der Grundplatte eingebracht, dass der dazwischen liegende separate Folienleiter dichtend, insbesondere öldicht, mit dem Gehäuse verbunden ist. Die Kontakte, die die elektrische Verbindung zwischen der Baugruppe und dem Folienleiter herstellen, führen dabei in die Aussparung hinein. Vorteilhafterweise erhöht sich dadurch die Prozesssicherheit. Wenn die elektrische Verbindung der außen liegenden elektrischen Bauteile zum Folienleiter schon vor der Kontaktierung des Folienleiters zur im Gehäuse liegenden Baugruppe hergestellt und geprüft wird, entfällt die durch einen eventuell erst nach der Endmontage festgestellten Fehler anfallende Nacharbeit. Ein weiterer Vorteil dieser Anordnung ist, dass die Dichtheit der Verbindung der Trägerplatte zur Grundplatte sofort nach der Herstellung dieser Verbindung geprüft werden kann. Dadurch entfällt eine durch einen eventuell erst nach der Endmontage festgestellten Fehler anfallende Nacharbeit.

Darüber hinaus hat die Anordnung den Vorteil, dass Änderungen im Gesamtlayout schnell und ohne großen materiellen und finanziellen Aufwand durchgeführt werden können. Dies ist vor allem in der Entwicklungsphase eines Produktes wichtig. Wird die Anordnung der elektrischen Baugruppen im Inneren des Gehäuses verändert, so kann durch Versetzen einer Aussparung oder durch Hinzufügen einer neuen Aussparung in der Grundplatte äußerst flexibel darauf reagiert werden, ohne dass die übrige Gesamtanordnung verändert werden muss. Falls nachträglich die Position elektrischer Bauteile außerhalb des Gehäuses verändert werden muss, sei es in x-,y-, oder z-Richtung, muss lediglich die Form der Positioniervorrichtung der elektrischen Bauteile außerhalb des Gehäuses verändert werden. Die elektrische Verbindung bleibt durch die Flexibilität des Folienleiters gewährleistet und die übrige Gesamtanordnung bleibt davon unberührt.

Vorzugsweise ist der flexible Folienleiter im Bereich der Durchführung mit der Grundplatte oder der Trägerplatte durch eine stoffschlüssige Verbindung wie Kleben oder Laminieren verbunden, wodurch der Grad der Dichtheit der Anordnung gesteigert und bei der Montage die Positionierbarkeit des flexiblen Folienleiters verbessert wird. Die Klebung kann auch durch ein doppelseitig klebendes Klebeband hergestellt werden. Vorteilhafterweise kann die Dichtwirkung der Anordnung noch erhöht werden, indem zwischen den flexiblen Folienleiter und die Grundplatte oder die Trägerplatte eine Dichtung eingebracht wird. Diese Dichtung kann in Form eines O-Rings, einer Kompressionsdichtung, eines elastischen Klebers oder einer Kragendichtung ausgestaltet sein.

Vorzugsweise ist in der Platte, die nicht in direktem Kontakt mit dem Folienleiter ist, eine Nut zur Aufnahme der Dichtung vorgesehen. Dadurch wird die Dichtung fixiert und der Zusammenbau der Anordnung erleichtert.

Nach einem besonders bevorzugten Ausführungsbeispiel der vorliegenden Erfindung ist die elektrische Einheit im Inneren des Gehäuses ein Steuergerät, das von außen liegenden elektrischen Bauteilen Signale empfängt und/oder außen liegende elektrische Bauteile steuert. Beispielsweise können die Signale von einem Temperatursensor stammen. Diese Information kann dazu verwendet werden, zum Beispiel ein Magnetventil zu steuern. Diese Anordnung ist äußerst kompakt und bietet eine sehr große Anzahl von verschiedenen Anwendungsmöglichkeiten.

Eine nähere Beschreibung der vorliegenden Erfindung erfolgt anhand der beigefügten Zeichnungen.
Fig.1 zeigt einen Auszug aus einer schematischen Querschnittansicht eines Gehäuses, das ein Steuergerät enthält;
Fig. 2 zeigt eine schematische Darstellung eines Schnitts durch die Fig. 3 in der Ebene A-A;
Fig. 3 zeigt eine schematische Ansicht wie Fig. 1, wobei eine Dichtung in einer Nut in der Stirnseite der Aussparung in der Grundplatte verläuft;
Fig. 4 zeigt eine schematische Ansicht wie Fig. 3, wobei eine Dichtung in einer Nut in der Trägerplatte verläuft.

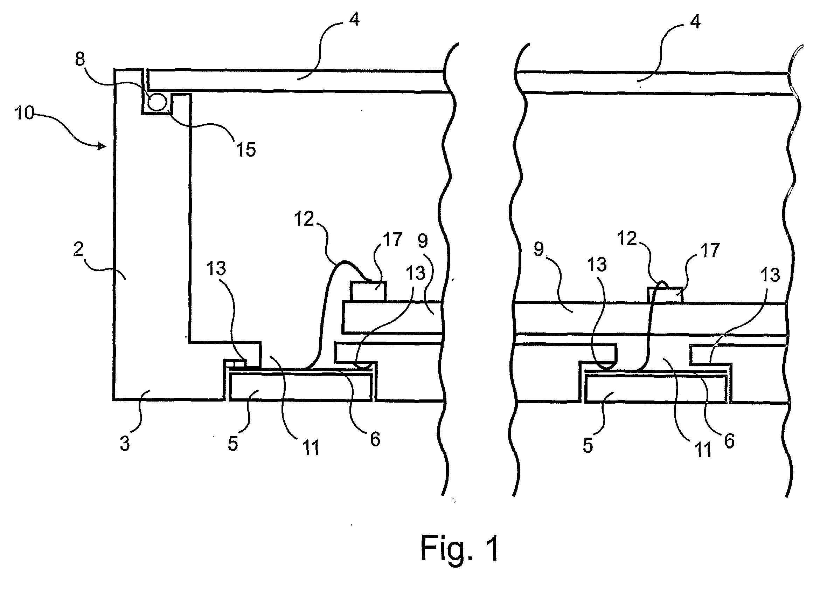

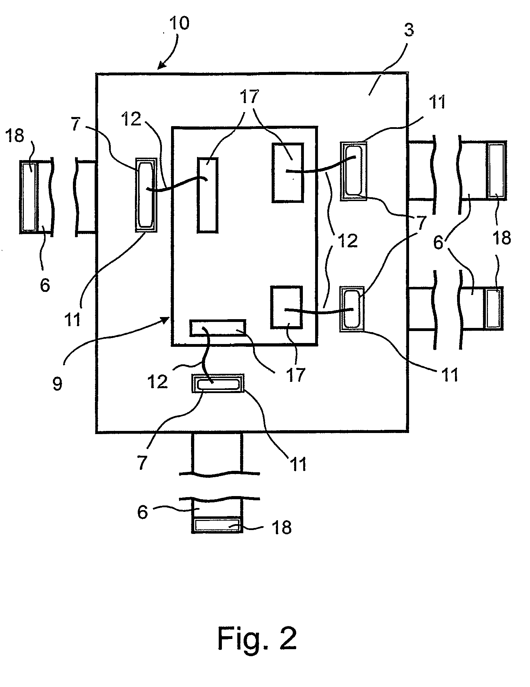

Nach Fig. 1 und 2 weist die Anordnung ein sich in einem Gehäuse 10 befindliches Steuergerät 9 auf, wobei das Gehäuse 10 einen Deckel 4, eine umlaufende Wandung 2, eine Grundplatte 3, die vorzugsweise einstückig mit der Wandung 2 ausgebildet ist, und wenigstens eine Trägerplatte 5 umfasst. Das Gehäuse 10 befindet sich in nicht gezeigter Weise unter der Getriebeglocke zwischen Getriebe und Hydraulikblock und ist somit auf der einen Seite von Getriebeöl und auf der anderen Seite von Hydrauliköl umgeben. Der Deckel 4 dichtet das Gehäuse 10 über die Dichtung 8, die in einer in der Stirnfläche der Wandung 2 umlaufenden Nut 15 platziert ist, gegen das Getriebeöl ab. Der Deckel 4 kann verschraubt oder verstemmt werden. Das Abdichten kann aber auch ohne Dichtung erfolgen. Dazu bildet die Stirnseite der umlaufenden Wandung 2 eine ebene Dichtfläche und der Deckel 4 wird unter hinreichendem Anpressdruck verschraubt oder verstemmt. Werden metallische Materialien verwendet, kann das Verbinden auch durch eine Schweißung geschehen.

Das Steuergerät 9 ist mit der Grundplatte 3 fest verbunden. Zwischen dem Steuergerät 9 und der umlaufenden Wandung 2 ist insbesondere derart ein Abstand belassen, dass die Trägerplatte 5 dort Platz findet.

Auf dem Steuergerät 9 befinden sich elektrische Baugruppen 17. Im Bereich einer Baugruppe 17, zwischen dem Steuergerät 9 und der umlaufenden Wandung 2, befindet sich in der Grundplatte 3 eine Aussparung 11. Durch diese Aussparung 11 hindurch wird jede elektrische Baugruppe 17 über einen separaten flexiblen Folienleiter 6 mit den elektrischen Bauteilen 18 außerhalb des Gehäuses 10 verbunden. Dabei kann es sich bei den Bauteilen 18 zum Beispiel um einen Sensor, wie einen Temperatursensor, oder einen Aktuator, wie ein Magnetventil, oder auch mehrere, auch verschiedene Bauteile, handeln. Die Bauteile 18 können sowohl in den Getriebe- als auch in den Hydraulikteil ragen. Diese Anordnung ermöglicht, dass die Leiterbahnen jedes separaten Folienleiters 6 aus parallelen Geraden bestehen und somit das Folienlayout insgesamt vereinfacht wird.

Die Verbindung zwischen der elektrischen Baugruppe 17 und dem jeweiligen flexiblen Folienleiter 6 geschieht durch die Kontakte 12, in diesem Fall Bonddrähte. Der flexible Folienleiter 6 ist durch die Trägerplatte 5 dichtend, insbesondere öldicht, an die Grundplatte 3 angeschlossen, indem die Trägerplatte 5 den flexiblen Folienleiter 6 gegen die Stirnseite 13 der Aussparung 11 drückt und durch Verschrauben oder Verstemmen mit der Grundplatte 3 fest verbunden wird. Die Dichtwirkung kann in nicht gezeigter Weise durch Anbringen einer zusätzlichen Dichtung zwischen Folienleiter 6 und Trägerplatte 5 oder Grundplatte 3 noch erhöht werden.

Vorteilhafterweise werden an den einzelnen Folienleiter 6, bevor an dem einen Ende der elektrische Kontakt 12 zur zugehörigen Baugruppe 17 im Gehäuse 10 hergestellt wird, am anderen Ende die jeweiligen elektrischen Bauteile 18 elektrisch kontaktiert und in eine nicht dargestellte Positioniervorrichtung eingeführt. Durch das gleichzeitige Anbringen von Trägerplatte 5, zugehörigem Folienleiter 6 und der zugehörigen Positioniervorrichtung werden die elektrischen Bauteile 18 schon in ihre endgültige Lage gebracht ist.

Nun wird der Kontakt 12 zwischen der elektrischen Baugruppe 17 im Inneren des Gehäuses 10 und dem separaten Folienleiter 6 hergestellt. So können die Module bestehend aus außenliegenden Bauteilen 18, Folienleiter 6, Positioniervorrichtung und Trägerplatte 5 nach und nach durch die jeweilige Aussparung 11 im Bereich der betreffenden Baugruppe 17 öldicht an die Grundplatte 3 angeschlossen werden.

Durch die Art der Anordnung kann sowohl das Gehäuse 10 als auch das Modul für ähnliche Anwendungen weitestgehend standardisiert werden. Sollte es sich darüber hinaus herausstellen, dass ein Kontakt 12 einer elektrischen Baugruppe 17 zum Folienleiter 6 fehlerhaft ist und ein Nachkontaktieren nicht möglich ist, wird lediglich das jeweilige Modul ausgetauscht.

Der flexible Folienleiter 6 kann mit der Trägerplatte 5 oder mit der Grundplatte 3 im Bereich der Aussparung 11 stoffschlüssig verbunden sein, beispielsweise durch Klebung oder Laminieren, wodurch die Dichtwirkung erhöht und die Positionierbarkeit des flexiblen Folienleiters 6 bei der Montage verbessert wird. Die Klebung kann insbesondere durch ein doppelseitig klebendes Klebeband geschaffen werden. In dem Fall, dass der Folienleiter 6 mit der Trägerplatte 5 schon vor dem Anschluss derselben an die Grundplatte 3 verbunden wird, und der Kontakt zum außen liegenden elektrischen Bauteil 18 oder den elektrischen Bauteilen 18 auch bereits vorher hergestellt worden ist, bekommt die ganze Anordnung einen modularen Charakter.

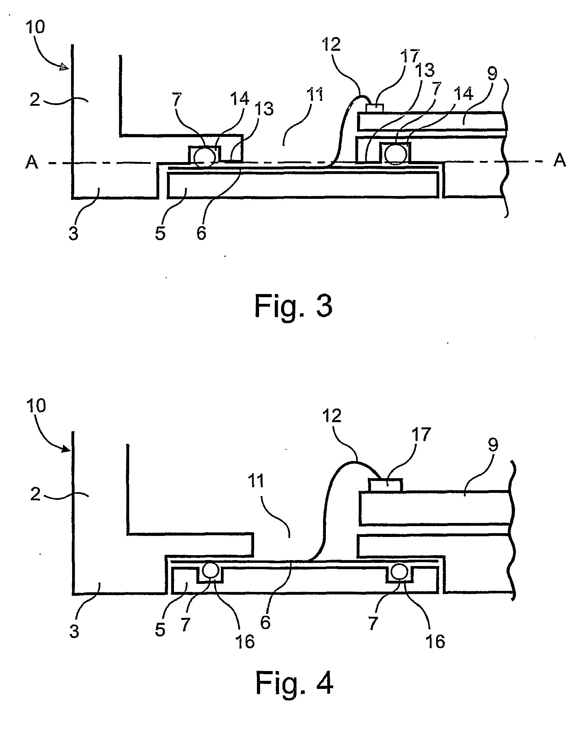

Fig. 3 zeigt das Anbringen einer Dichtung 7 in einer Nut 14, die in der Stirnseite 13 der Aussparung 11 umläuft. Dadurch wird die Montage der Anordnung erleichtert, indem die Dichtung 7 in der Nut 14 in ihrer Lage fixiert wird.

Fig. 4 zeigt das Anbringen einer Dichtung 7 in einer Nut 16 auf der Trägerplatte 5, wobei die Form der Nut 16 der Form der Stirnseite 13 der Aussparung 11 folgt. Die Dichtungen 7 und/oder 8 können in Gestalt eines O-Ringes, einer Kompressionsdichtung, eines elastischen Klebers oder einer Kragendichtung ausgebildet sein.

### Bezugszeichenliste

- 2: Wandung
- 3: Grundplatte
- 4: Deckel
- 5: Trägerplatte
- 6: Flexibler Folienleiter
- 7: Gehäusedichtung, Trägerplatte
- 8: Gehäusedichtung, Wandung
- 9: Elektrische Einheit
- 10: Gehäuse
- 11: Aussparung
- 12: Kontakt
- 13: Stirnseite der Aussparung
- 14: Nut in der Stirnseite der Aussparung
- 15: Nut in der Wandung
- 16: Nut in der Trägerlatte
- 17: Elektrische Baugruppe
- 18: Elektrische Bauteile außerhalb des Gehäuses

## Patentansprüche

1. Anordnung zum elektrischen Verbinden einer elektrischen Einheit (9), wobei die elektrische Einheit (9) auf einer Grundplatte (3) im Inneren eines Gehäuses (10) angeordnet ist und wobei die elektrische Einheit (9) mehrere elektrische Baugruppen (17) umfasst, die jeweils über einen separaten Folienleiter (6) mit wenigstens einem außerhalb des Gehäuses (10) vorgesehenen elektrischen Bauteil (18) verbunden sind, **dadurch gekennzeichnet, dass** sich Aussparungen (11) in der Grundplatte (3) befinden, und dass durch jeweils eine dieser Aussparungen (11) hindurch jeweils eine elektrische Baugruppe (17) über den separaten flexiblen Folienleiter (6) mit dem wenigstens einen zugehörigen elektrischen Bauteil (18) außerhalb des Gehäuses verbunden ist, wobei die separaten Folienleiter (6) auf der der elektrischen Einheit gegenüberliegenden Seite der Grundplatte angeordnet sind.

2. Anordnung nach Anspruch 1, **dadurch gekennzeichnet, dass** das Gehäuse (10) einen Deckel (4), eine umlaufende Wandung (2), die Grundplatte (3), die vorzugsweise einstückig mit der Wandung (2) ausgebildet ist, und wenigstens eine Trägerplatte (5) zur dichten Anbindung des Folienleiters (6) an die Grundplatte (3) umfasst.

3. Anordnung nach Anspruch 2', **dadurch gekennzeichnet, dass** die elektrische Einheit (9) mit einem Abstand zur umlaufenden Wandung (2) auf der Grundplatte (3) montiert ist, wobei sich die Trägerplatte (5) zwischen der Wandung (2) und der elektrischen Einheit (9) befindet.

4. Anordnung nach einem der Ansprüche 2 oder 3, **dadurch gekennzeichnet, dass** die Grundplatte (3) benachbart zu einer Baugruppe (17) eine Aussparung (11) aufweist, in die elektrische Kontakte (12) zwischen der Baugruppe (17) und dem separaten Folienleiter (6) hineingeführt sind.

5. Anordnung nach Anspruch 4, **dadurch gekennzeichnet, dass** zumindest eine Trägerplatte (5) so in die Aussparung (11) in der Grundplatte (3) eingebracht ist, dass der dazwischen liegende Folienleiter (6) dichtend, insbesondere öldicht, mit dem Gehäuse (10) verbunden ist.

6. Anordnung nach einem der Ansprüche 2 bis 5, **dadurch gekennzeichnet, dass** der Folienleiter (6) mit wenigstens einem Gehäuseteil (3, 5) durch eine stoffschlüssige Verbindung, wie beispielsweise Kleben oder Laminieren, verbunden ist.

7. Anordnung nach einem der Ansprüche 2 bis 6, **dadurch gekennzeichnet, dass** zwischen zumindest einem Gehäuseteil (3, 5) und dem Folienleiter (6) eine Dichtung (7) angebracht ist, die vorzugsweise in ihrer Form einer Stirnseite (13) der Aussparung (11) folgt.

8. Anordnung nach Anspruch 7, **dadurch gekennzeichnet, dass** an dem Gehäuseteil (3, 5), das in direktem Kontakt mit der Dichtung (7) steht, eine Nut (14, 16) zur Aufnahme der Dichtung (7) vorgesehen ist.

9. Anordnung nach einem der vorherigen Ansprüchen, **dadurch gekennzeichnet, dass** die elektrische Einheit (9) ein Steuergerät ist und die elektrischen Bauteile (18)außerhalb des Gehäuses (10) Aktuatoren und/oder Sensoren sind.

## Claims

1. Arrangement for electrically connecting an electrical unit (9), wherein the electrical unit (9) is arranged on a base plate (3) inside a case (10), and wherein the electrical unit (9) comprises several electrical assemblies (17), each of them being connected, via a separate foil conductor (6), to at least one electrical component (18) provided outside the case (10), **characterized in that** the base plate (3) has recesses (11), and that one electrical assembly (17) a time is connected, through one of said recesses (11) a time and via the separate flexible foil conductor (6), to the at least one associated electrical component (18) outside the case, wherein the separate foil conductors (6) are arranged on that side of the base plate which is arranged opposite the electrical unit.

2. Arrangement according to claim 1, **characterized in that** the case (10) comprises a top cover (4), a circumferential wall (2), the base plate (3) that preferably forms a single piece with the wall (2), and at least one bearing plate (5) for the tight connection of the foil conductor (6) to the base plate (3).

3. Arrangement according to claim 2, **characterized in that** the electrical unit (9) is mounted to the base plate (3) in such a manner that a space is formed between the electrical unit (9) and the circumferential wall (2), wherein the bearing plate (5) is arranged between the wall (2) and the electrical unit (9).

4. Arrangement according to any one of claims 2 or 3, **characterized in that** the base plate (3) comprises a recess (11) adjacent to an assembly (17), wherein electrical contacts (12) between the assembly (17) and the separate foil conductor (6) extend into the recess (11).

5. Arrangement according to claim 4, **characterized in that** at least one bearing plate (5) is arranged in the recess (11) of the base plate (3) in such a manner that the intermediate foil conductor (6) is connected to the case (10) in a sealing-tight, in particular, in an oiltight fashion.

6. Arrangement according to any one of claims 2 to 5, **characterized in that** the foil conductor (6) is integrally joined to at least one case part (3, 5) by, for example, adhesive bonding or laminating.

7. Arrangement according to any one of claims 2 to 6, **characterized in that** a seal (7) is arranged between at least one case part (3, 5) and the foil conductor (6), wherein the shape of the seal (7) preferably follows the shape of a front (13) of the recess (11).

8. Arrangement according to claim 7, **characterized in that** the case part (3, 5) that directly contacts the seal (7) is provided with a groove (14, 16) for receiving the seal (7).

9. Arrangement according to any one of the preceding claims, **characterized in that** the electrical unit (9) is a control device and that the electrical components (18) arranged outside the case (10) are actuators and/or sensors.

## Revendications

1. Dispositif pour la connexion électrique d'une unité électrique (9), l'unité électrique (9) étant disposée sur une platine (3) à l'intérieur d'un boîtier (10), et l'unité électrique (9) comprenant plusieurs sous-ensembles (17) électriques qui sont connectés respectivement par le biais d'une feuille conductrice (6) séparée à au moins un composant (18) électrique prévu à l'extérieur du boîtier (10), **caractérisé en ce que** des évidements (11) sont situés dans la platine (3) et **en ce que**, à travers respectivement un de ces évidements (11), respectivement un sous-ensemble (17) électrique est, par le biais de la feuille conductrice (6) flexible séparée, connecté au composant (18) électrique associé au moins au nombre de un à l'extérieur du boîtier, les feuilles conductrices (6) séparées étant disposées sur le côté de la platine opposé à l'unité électrique.

2. Dispositif selon la revendication 1, **caractérisé en ce que** le boîtier (10) comprend un couvercle (4), une paroi (2) périphérique, la platine (3), qui est de préférence constituée d'un seul tenant avec la paroi (2), et au moins une plaque support (5) pour un attachement serré de la feuille conductrice (6) à la platine (3).

3. Dispositif selon la revendication 2, **caractérisé en ce que** l'unité électrique (9) est montée sur la platine (3) à distance de la paroi (2) périphérique, la plaque support (5) se trouvant entre la paroi (2) et l'unité électrique (9).

4. Dispositif selon une des revendications 2 ou 3, **caractérisé en ce que** la platine (3) présente, au voisinage d'un sous-ensemble (17), un évidement (11) dans lequel des contacts électriques (12) entre le sous-ensemble (17) et la feuille conductrice (6) sont introduits.

5. Dispositif selon la revendication 4, **caractérisé en ce qu'**au moins une plaque support (5) est mise en place dans l'évidement (11) dans la platine (3) de sorte que la feuille conductrice (6) située en position intermédiaire est connectée au boîtier (10) de façon étanche, en particulier de façon étanche à l'huile.

6. Dispositif selon une des revendications 2 à 5, **caractérisé en ce que** la feuille conductrice (6) est raccordée à au moins une partie de boîtier (3,5) par une liaison par adhérence, comme par exemple par encollage ou laminage.

7. Dispositif selon une des revendications 2 à 6, **caractérisé en ce que**, entre au moins une partie de boîtier (3,5) et la feuille conductrice (6), il est mis en place un joint d'étanchéité (7) qui de préférence suit par sa forme un côté frontal (13) de l'évidement (11).

8. Dispositif selon la revendication 7, **caractérisé en ce que**, sur la partie de boîtier (3,5) qui est en contact direct avec le joint d'étanchéité (7), il est prévu une rainure (14, 16) pour loger le joint d'étanchéité (7).

9. Dispositif selon une des revendications précédentes, **caractérisé en ce que** l'unité électrique (9) est un appareil de commande, et **en ce que** les composants (18) électriques à l'extérieur du boîtier (10) sont des actionneurs et/ou des capteurs.
